# EUROPEAN PATENT APPLICATION

(11) **EP 4 284 126 A1**
(43) Date of publication of application: **29.11.2023**
(21) Application number: 22200861.7
(22) Date of filing: 11.10.2022
(51) Int. Cl.: H05K 5/00, H05K 5/02, H05K 7/14, G06F 1/26, H02J 7/00, H01R 12/00

(54) **A POWER ADAPTER**

(30) Priority: 23.05.2022 CN 202221249785 U
(71) Applicant: Zhejiang Lvli Intelligent Technology Co., Ltd., Taizhou City, Zhejiang Province 318000 (CN)
(72) Inventor: Ping, Liang, Taizhou City, Zhejiang Province, 318000 (CN)
(74) Representative: Cabinet Chaillot

(57) **Abstract**

The present application belongs to the technical field of driving power supply, and in particular relates to a power adapter, which includes a casing, an end cover, a circuit board, pins and conductive element. The pin is arranged on the casing, and the pin is inserted and matched with the circuit board through the card board group. One side of the casing is open, the end cover is arranged on the casing and closes the casing to form an accommodating cavity, the circuit board is arranged in the accommodating cavity; conductive element includes a connecting piece and a conducting piece that are connected to each other. The connecting piece passes through the end cover, the conducting piece comprises a first elastic sheet and a second elastic sheet, and a card slot is formed between the first elastic sheet and the second elastic sheet. In the present application, the connecting piece is inserted into the waterproof seat, the first elastic sheet and the second elastic sheet are elastically clamped to the circuit board, so the installation speed is fast, the installation method is convenient, the assembly efficiency is improved, and the connection between the circuit board and the conductive element is stable, and it is not easy to be disconnected, which ensures the normal use of the power adapter.

## Description

### Technical field

The present application belongs to the technical field of driving power supply, and in particular relates to a power adapter.

### Background technique

A power adapter is a power conversion device that converts AC input to DC output, and it is generally composed of such components as enclosure, transformer, inductor, capacitor, control IC and PCB board. The power adapters are widely used in lamps, camera devices, game consoles and other equipment.

When assembling the power adapters in the current market, it is necessary to connect the circuit board with the power connection part through wires. Since the power connection part is fixed on the shell, the space inside the shell is small, the space of the wire is limited during the welding process, which makes the operation difficult, time-consuming and laborious, and the connection between the wire and the welding point is not stable. When the wire shakes during use, the wire It is easy to be disconnected from the circuit board, which affects the normal use of the power adapter.

### Summary of the invention

In order to solve the above technical problems, the technical solution of the present application provides a power adapter. The technical solution is as follows:
The application is implemented in this way, a power adapter, including:
a casing, an end cover, a circuit board, pins and conductive element, the pin is arranged on the casing , and the pin is inserted and matched with the circuit board through the card board group, one side of the casing is open, the end cover is arranged on the casing and closes the casing to form an accommodating cavity, the circuit board is arranged in the accommodating cavity;
the conductive element includes a connecting piece and a conducting piece that are connected to each other, the connecting piece passes through the end cover, the conducting piece comprises a first elastic sheet and a second elastic sheet which oppositely arranged in the accommodating cavity, a card slot is formed between the first elastic sheet and the second elastic sheet, the card slot is configured to be inserted and matched with the output end of the circuit board.

Further, the second elastic sheet includes a straight plate portion and an arc plate portion, the arc plate portion is arranged at the end portion of the straight plate portion which closes to the circuit board, and the arc plate portion is in the shape of a concave arc plate.

Specifically, the distance between the straight plate portion and the circuit board gradually decreases along the direction close to the arc plate portion.

Particularly, the first elastic sheet and the straight plate part are connected by a transition piece, and an extension part is formed on the arc plate part.

Further, a waterproof seat is formed on the end cover, and the end of the connecting piece which away from the circuit board is inserted into the waterproof seat.

Specifically, two opposite side walls of the connecting piece are provided with serrations, and the serrations are inserted into the end cover.

Particularly, the cross section of the connecting piece is arranged in a U-shape.

Further, an installation hole is opened on the end cover, and an elastic seal is arranged in the installation hole.

Specifically, two conducting piece are symmetrically arranged in the accommodating cavity, and the conducting pieces and connecting pieces are arranged in one-to-one correspondence.

Further, the elastic seal is provided with a bump, and the circuit board also has a contact button, when the bump is in a depressed state, the elastic seal abuts against the contact button to realize the circuit connection on the circuit board.

Compared with the prior art, the present application has the following beneficial effects: The connecting piece is inserted into the waterproof seat, and the first shrapnel, the second shrapnel and the extension part are elastically clamped to the circuit board. The installation speed is fast, the installation method is convenient, and the assembly efficiency is improved without damaging the circuit board. At the same time, the increased elastic clamping force of the arc plate makes the connection between the circuit board and the conducting pieces stable and not easy to disengage, which ensures the normal use of the power adapter.

### Description of drawings

The accompanying drawings, which are incorporated in and constitute a part of this specification, illustrate embodiments consistent with the application and together with the description serve to explain the principles of the application, wherein:
FIG. 1 is an overall structure schematic diagram of the present application;
FIG. 2 is a schematic structural diagram of the circuit board embodied in the present application;
FIG. 3 is a schematic diagram of the circuit board and pins connection structure in the present application;
FIG. 4 is a schematic structural diagram of the waterproof seat in the present application;
FIG. 5 is a schematic structural diagram of the conducting piece of the present application;
FIG. 6 is a schematic structural diagram of the conducting piece inserted in the end cover of the present application.

Reference number: 1, casing; 11, pin; 2, end cover; 21, waterproof seat; 22, elastic seal; 23, bump; 3, circuit board; 31, card board body; 32, contact button; 4, conductive element; 5, connecting piece; 51, serrations; 6, conducting piece; 61, first elastic sheet; 611, protrusion; 62, second elastic sheet; 621, straight plate portion; 622, arc plate portion; 63, straight plate portion; 7, card slot; 8, extension part.

### Embodiments of the present invention

The following disclosure provides many different embodiments or examples for implementing different structures of the present application. To simplify the disclosure of the present application, the components and arrangements of specific examples are described below. Of course, they are only examples and are not intended to limit the application. Furthermore, this application may repeat reference numerals and/or reference letters in different instance, such repetition is for the purpose of simplicity and clarity and does not in itself indicate the relationship between the various embodiments and/or arrangements discussed.

A power adapter is a power conversion device that converts AC input to DC output, and it is generally composed of such components as enclosure, transformer, inductor, capacitor, control IC and PCB board. The power adapters are widely used in lamps, camera devices, game consoles and other equipment.

When assembling the power adapters in the current market, it is necessary to connect the circuit board with the power connection part through wires. Since the power connection part is fixed on the shell, the space inside the shell is small, the space of the wire is limited during the welding process, which makes the operation difficult, time-consuming and laborious, and the connection between the wire and the welding point is not stable. When the wire shakes during use, the wire It is easy to be disconnected from the circuit board, which affects the normal use of the power adapter.

The purpose of the present application is to provide a power adapter, which aims to solve the above technical problem.

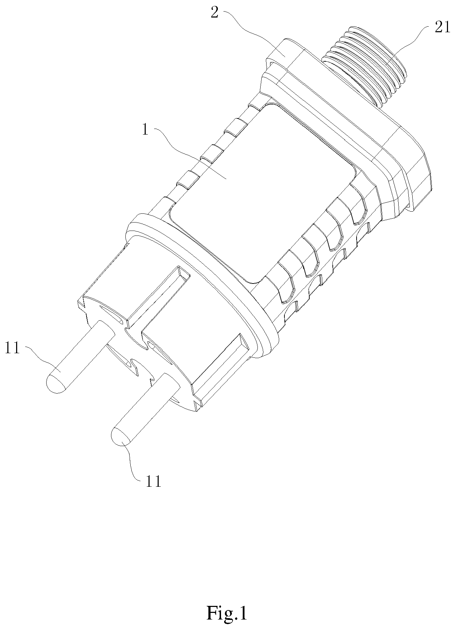

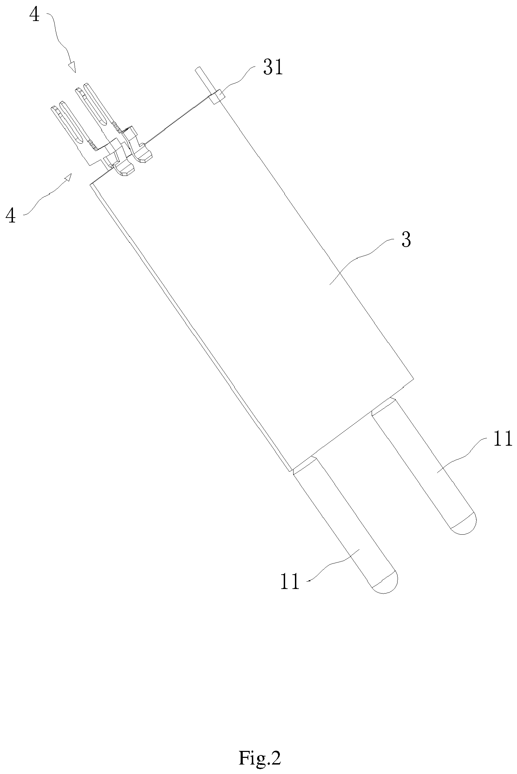

The present application will be described in further detail below according to FIG. 1 to FIG. 6:
As shown in FIG. 1 and FIG. 2, the present application provides a power adapter, comprising a casing 1, an end cover 2, a circuit board 3 and two symmetrically arranged conductive elements 4.One end surface of the casing 1 is open, and the other end surface is fixedly inserted with two pins 11.

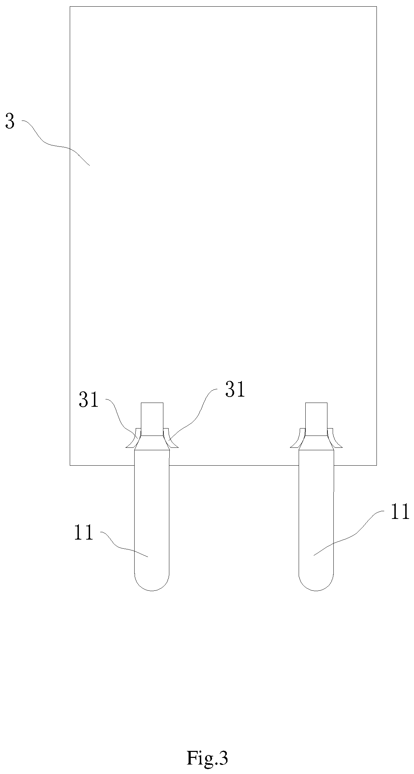

As shown in FIG. 1 and FIG. 3, the circuit board 3 is provided with card board groups, and each card board group includes two card board bodies 31, and the two card board bodies 31 are arranged opposite to each other in the shape of "A". One end of the pins 11 is inserted between the two card board bodies 31 to realize the snap fit between the card board group and the pins 11.

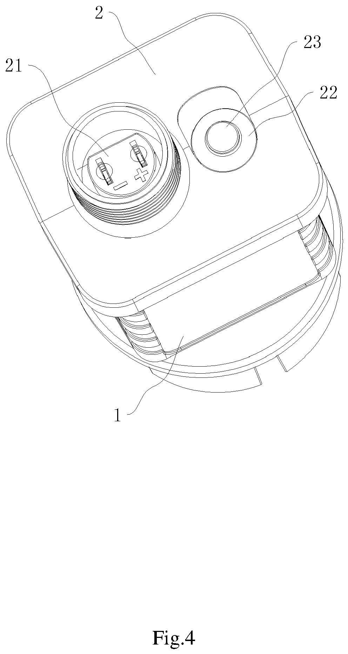

As shown in Figure 2 and Figure 4, the end cover 2 is arranged at the opening of the casing 1 ,and the end cover 2 is inserted and matched with the casing 1, then the casing 1 is closed to form an accommodating cavity, the circuit board 3 is arranged in the accommodating cavity. A waterproof seat 21 is formed on the side of the end cover 2 which is away from the casing 1.An installation hole is provided on the end cover 2, and an elastic seal 22 is provided in the installation hole, and the elastic seal 22 can be a rubber button.

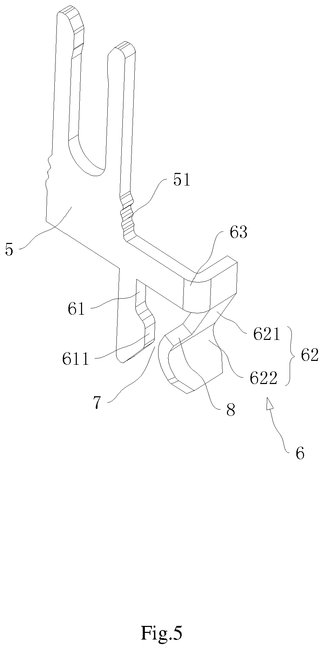

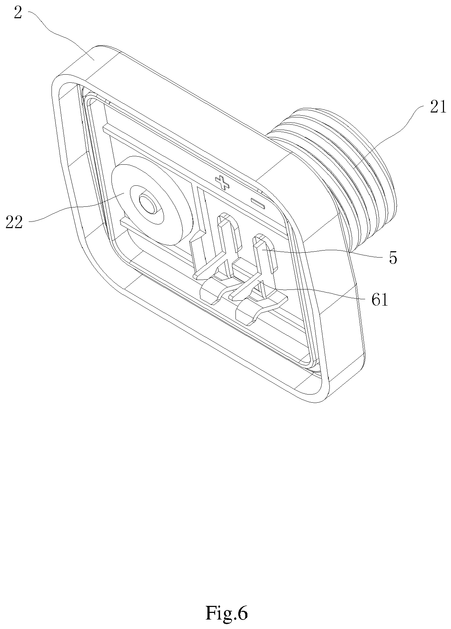

As shown in Figure 5 and Figure 6, the conductive element 4 includes a connecting piece 5 and a conducting piece 6. One end of the connecting piece 5 is fixedly inserted in the waterproof seat 21, and the other end is extended into the accommodating cavity through the end cover 2. The cross-section of the connecting piece 5 is arranged in a U-shape, and the two opposite side walls of the connecting piece 5 are provided with serrations 51 .The serrations 51 are inserted into the end cover 2, which increases the friction between the serrations 51 and the end cover 2, then reduces the possibility of displacement of the connecting piece 5, and improves the stability of the connecting piece 5.

As shown in Figure 2 and Figure 5, the conducting piece 6 is fixedly connected to the side wall at the broad side of the connecting piece 5, and the conducting piece 6 is located at one end of the connecting piece 5, which close to the circuit board 3.The conducting piece 6 includes a first elastic sheet 61 and a second elastic sheet 62. The first elastic sheet 61 and the second elastic sheet 62 are fixedly connected by a transition piece 63.The second elastic sheet 62; the first elastic sheet 61 and the transition piece 63 are integrally formed. The first elastic sheet 61 and the second elastic sheet 62 are arranged opposite to each other, and a card slot 7 is formed between the first elastic sheet 61 and the second elastic sheet 62. The output end of the circuit board 3 is located in the card slot 7, and the circuit board 3 is clipped to the conducting piece 6 through the card slot 7.

As shown in Figure 2 and Figure 5, the first elastic sheet 61 is provided in a straight plate shape, and a protrusion 611 is formed on the side of the first elastic sheet 61 which facing the second elastic sheet 62 .The second elastic sheet 62 includes a straight plate portion 621 and an arc plate portion 622. One end of the straight plate portion 621 is connected to the adapter plate 63, and the other end is connected to the arc plate portion 622, and the arc plate portion 622 is an arc plate concave toward the circuit board 3.

As shown in Figure 2 and Figure 5, along the direction from the connecting piece 5 to the conducting piece 6, the distance between the straight plate portion 621 and the circuit board 3 is gradually reduced, which enhances the distance between the second elastic sheet 62 and the circuit board 3.The clamping force improves the clamping stability of the second elastic sheet 62 and the circuit board 3.In addition, the extension part 8 is formed on the arc plate portion 622, which increases the contact area between the second elastic sheet 62 and the circuit board 3, further realizes stable clamping, and effectively ensures the normal operation of the power adapter.

As shown in FIG. 2 and FIG. 4, in addition, the elastic seal 22 is provided with a bump 23, and the circuit board 4 also has a contact buttons 32. When the bump 23 is in a depressed state, the elastic seal 22 is in contact with the contact button 32 to realize the circuit connection of the circuit board 3.

The implementation principles of the embodiments of the present application are as follows: the connecting piece 5 is inserted in the waterproof seat 21.The first elastic sheet 61; the second elastic sheet 62 and the extension part 8 are elastically clamped to the circuit board 3. Under the condition that the circuit board 3 is not damaged, the installation speed is fast and the installation method is convenient, thereby improving the assembly efficiency. At the same time, the clamping force of the elastic clamping increased by the arc plate portion 622, then the circuit board 3 and the conductive element 4 are connected stably and are not easily disengaged, which ensures the normal use of the power adapter.

Other embodiments of the present application will readily occur to those skilled in the art upon consideration of the specification and practice of the invention disclosed herein. This application is intended to cover any variations, uses or adaptations of this application that follow the general principles of this application and include common general knowledge or conventional techniques in the technical field of this application. The specification and examples are to be regarded as exemplary only, with the true scope and spirit of the application being indicated by the claims.

It is to be understood that the present application is not limited to the precise structures described above and shown in the accompanying drawings and that various modifications and changes may be made without departing from the scope thereof. The scope of the application is limited only by the appended claims.

## Claims

1. A power adapter, **characterized in that** it includes a casing, an end cover, a circuit board, pins and conductive element, the pin is arranged on the casing , and the pin is inserted and matched with the circuit board through the card board group, one side of the casing is open, the end cover is arranged on the casing and closes the casing to form an accommodating cavity, the circuit board is arranged in the accommodating cavity;
the conductive element includes a connecting piece and a conducting piece that are connected to each other, the connecting piece passes through the end cover, the conducting piece comprises a first elastic sheet and a second elastic sheet which oppositely arranged in the accommodating cavity, a card slot is formed between the first elastic sheet and the second elastic sheet, the card slot is configured to be inserted and matched with the output end of the circuit board.

2. The power adapter of claim 1, wherein the second elastic sheet includes a straight plate portion and an arc plate portion, the arc plate portion is arranged at the end portion of the straight plate portion which closes to the circuit board, and the arc plate portion is in the shape of a concave arc plate.

3. The power adapter of claim 2, wherein the distance between the straight plate portion and the circuit board gradually decreases along the direction close to the arc plate portion.

4. The power adapter of claim 2, wherein the first elastic sheet and the straight plate part are connected by a transition piece, and an extension part is formed on the arc plate part.

5. The power adapter of claim 1,wherein a waterproof seat is formed on the end cover, and the end of the connecting piece which away from the circuit board is inserted into the waterproof seat.

6. The power adapter of claim 1, wherein two opposite side walls of the connecting piece are provided with serrations, and the serrations are inserted into the end cover.

7. The power adapter of claim 1, wherein the cross section of the connecting piece is arranged in a U-shape.

8. The power adapter of claim 1, wherein an installation hole is opened on the end cover , and an elastic seal is arranged in the installation hole.

9. The power adapter of claim 1, wherein two conducting piece are symmetrically arranged in the accommodating cavity, and the conducting pieces and connecting pieces are arranged in one-to-one correspondence.

10. The power adapter of claim 9, wherein the elastic seal is provided with a bump, and the circuit board also has a contact button, when the bump is in a depressed state, the elastic seal abuts against the contact button to realize the circuit connection on the circuit board.
